# EUROPEAN PATENT SPECIFICATION

(11) **EP 4 229 666 B1**
(45) Date of publication and mention of the grant of the patent: **25.11.2026**
(21) Application number: 21790376.4
(22) Date of filing: 07.10.2021
(51) Int. Cl.: H01H 9/50, H01H 9/54, H02H 3/08

(54) **ARC FLASH MITIGATION DEVICE**
STÖRLICHTBOGENBEGRENZUNGSEINRICHTUNG
DISPOSITIF D'ATTÉNUATION DE L'ÉCLAIR D'ARC

(30) Priority: 14.10.2020 US 202017070475
(43) Date of publication of application: 23.08.2023
(73) Proprietor: Eaton Intelligent Power Limited, Dublin 4 (IE)
(72) Inventor: ZHOU, Xin, Wexford, PA 15090 (US); CARLSON, Brian, E., Moon Township, PA 15108 (US); LANG, Brooke, E., Pittsburg, PA 15241 (US); GRIFFIN, Robert, P., Bradfordwoods, PA 15015 (US)
(74) Representative: Schwan Schorer & Partner mbB
(86) International application number: PCT/EP2021/025398
(87) International publication number: WO 2022/078627

(56) References cited:
- EP-A1- 3 118 954
- EP-A1- 3 229 252
- US-A1- 2012 243 137
- US-A1- 2015 280 421
- US-A1- 2020 211 803

## Description

### BACKGROUND

The document describes devices, systems and methods that are directed to electrical power protection devices, systems and methods and, more particularly, to an arc flash mitigation device to protect maintenance personnel and electrical power equipment.

Arc flash events can cause significant damage to power distribution systems such as switchgear and panel boards, as well as personnel injuries. Circuit breakers and fuses can be used in switchgear to provide protection when there is a short circuit fault. However, current protection systems have a relatively long response time to interrupt propagating hazardous currents associated with a short circuit fault and eliminate arc flash events, especially when it is a fault caused by low level overcurrent.

In US 2015/280421 A1 there is disclosed a device as it is defined in the preamble of claim 1.

It is desirable to have arc flash mitigation devices with even shorter response times to provide additional protection in the event of arc flash events.

### SUMMARY

The present invention is a device as it is defined in claim 1 and a method as it is defined in the pre-characterizing portion of claim 11. The device includes an electro-mechanical switching device having an open-circuit condition and a closed-circuit condition. The electro-mechanical switching device comprises an electro-mechanical switch actuatable between an open state corresponding to the open-circuit condition and a closed state corresponding to the closed-circuit condition. The device includes a path of least resistance having a path input and a path output with the electro-mechanical switching device between the path input and the path output. The device also includes a bypass power switch device that includes a solid-state circuit interrupter which is configured to conduct current between the path input and the path output, in response to an open-circuit condition of the electro-mechanical switching device. The solid-state circuit interrupter comprises a first transistor and a second transistor. A current sensor is connected to the path output and is configured to detect a fault current event. The device includes an actuator that is coupled to the electro-mechanical switching device and a controller. Based on the detected fault current event, the controller generates a trigger signal to activate the actuator to cause the open-circuit condition of the electro-mechanical switching device and to interrupt the fault current event by the bypass power switch device. In accordance with the present invention, the electro-mechanical switch is the only switch connected between the path input and the path output in the path of least resistance, wherein the bypass power switch is connected to the path of least resistance at a first node and a second node, the first node being at the path input, the second node being disposed between the electro-mechanical switching device and the path output; wherein interrupting the fault current event by the bypass power switch device comprises channeling current at the second node to the bypass power switch device in order to bypass a portion of the path of least resistance, and wherein the first transistor and the second transistor are configured to complete interruption of the fault current event.

In various embodiments, the current sensor may have an output that is connected to a sensor input of the controller. The current sensor may be configured to communicate a signal representative of detection of the fault current event to the sensor input of the controller.

In various embodiments, the device may further include an external control panel connected to a control panel input of the controller. The external control panel may be configured to provide a user interface to control operations of the controller.

In various embodiments, the controller may also be configured to, in response to receiving a disarming control signal at the control panel input, cause in the path of least resistance the closed-circuit condition of the electro-mechanical switching device. The controller may also be configured to, in response to receiving an arming control signal at the control panel input, cause in the path of least resistance the open-circuit condition of the electro-mechanical switching device.

In various embodiments, the solid-state circuit interrupter may include at least one transient-voltage suppression (TVS) diode that has a first end connected to the path input and a second end connected to the path of least resistance between the electro-mechanical switching device and the path output. The solid-state circuit interrupter may also include a bi-directional transistor switch that has a first connection connected to the first end and the path input and a second connection connected to the second end and the path output.

In various embodiments, the at least one TVS diode comprises parallel TVS diodes.

In various embodiments, the device may further include a housing for housing the electro-mechanical switching device, the path of least resistance, the bypass power switch device and the controller. The housing may include a molded case circuit breaker or an air circuit breaker.

In various embodiments, the electro-mechanical switching device may include a vacuum interrupter. Additionally, the actuator may include a Thompson coil or piezo-electric actuator connected to the vacuum interrupter.

In various embodiments, the bypass power switch device also may include a cooling device.

In various embodiments, the detected fault current event may include a current associated with an arc flash event.

The method of the present invention includes controlling, in a path of least resistance including a path input and a path output and an electro-mechanical switching device that is between the path input and the path output, wherein the electro-mechanical switching device comprises an electro-mechanical switch. The method includes detecting, by a current sensor, a fault current event at the path output and generating, by a controller, a trigger signal to activate an actuator coupled to the electro-mechanical switching device. In response to the activation of the actuator, the method includes causing an open-circuit condition of the electro-mechanical switching device in the path of least resistance. In response to the open-circuit condition, the method includes interrupting the detected fault current event by a bypass power switch device that comprises a solid-state circuit interrupter connected to the path input and the path output, the solid-state circuit interrupter comprising a first transistor and a second transistor. In accordance with the present invention, the electro-mechanical switch is the only switch connected between the path input and the path output in the path of least resistance, and the bypass power switch device is connected to the path input at a first node and to the path output at a second node the second node being disposed between the electro-mechanical switching device and the path output, wherein interrupting the fault current event by the bypass power switch device comprises channeling current at the second node to the bypass power switch device in order to bypass a portion of the path of least resistance, and wherein the first transistor and the second transistor are configured to complete interruption of the fault current event.

In various embodiments, the method may include controlling, by an external control panel connected to a control panel input of the controller, operations of the controller.

In various embodiments, the controlling, by the controller, may include, in response to a disarming control signal received at the control panel input of the controller, causing a closed-circuit condition of the electro-mechanical switching device from the path input to the path output. Also the controlling, by the controller, may include, in response to an arming control signal received at the control panel input of the controller, causing the open-circuit condition of the electro-mechanical switching device.

In various embodiments, the interrupting by the bypass power switch device may include passing the fault current event to at least one transient-voltage suppression (TVS) diode of the solid-state circuit interrupter connected to the path of least resistance between the electro-mechanical switching device and the path output, to suppress a transient voltage.

In various embodiments, the bypass power switch device may include a cooling device. The method may further include cooling the bypass power switch device by the cooling device.

In various embodiments, the bypass power switch device has a response time between 100 microseconds and 0.5 milliseconds to interrupt the detected fault current event.

### BRIEF DESCRIPTION OF THE DRAWINGS

FIG. 1 illustrates a block diagram of a system employing an arc flash mitigation device.
FIG. 2A illustrates a schematic diagram of an arc flash mitigation device in a first mode of operation according to some embodiments.
FIG. 2B illustrates a schematic diagram of the arc flash mitigation device in a second mode of operation in according to some embodiments.
FIG. 3 illustrates a block diagram of a controller of the arc flash mitigation device of FIGS. 2A-2B interfaced with components of the device.
FIG. 4A illustrates a front perspective view of an arc flash mitigation device with a housing with a molded case circuit breaker (MCCB) form factor.
FIG. 4B illustrates an end and side perspective view of the arc flash mitigation device of FIG. 4A with a portion of the housing removed.
FIG. 4C illustrates a side view of the arc flash mitigation device of FIG. 4A with a portion of the housing removed.
FIG. 5 illustrates in an electrical panelboard.
FIG. 6A illustrates a front perspective view of an arc flash mitigation device with a housing with an air circuit breaker (ACB) form factor.
FIG. 6B illustrates a front perspective view of the arc flash mitigation device of FIG. 6A with a portion of the housing removed.
FIG. 7 illustrates a front perspective view of an arc flash mitigation device with a housing with a cassette form factor.
FIG. 8 depicts an example of internal hardware that may be included in any of the electronic components of the system, such as internal processing systems of computing devices, controllers and sensors.

### DETAILED DESCRIPTION

Specific exemplary embodiments of the inventive subject matter now will be described with reference to the accompanying drawings. This inventive subject matter may, however, be embodied in many different forms and should not be construed as limited to the embodiments set forth herein; rather, these embodiments are provided so that this disclosure will be thorough and complete, and will fully convey the scope of the inventive subject matter to those skilled in the art. In the drawings, like numbers refer to like items. It will be understood that when an item is referred to as being "connected" or "coupled" to another item, it can be directly connected or coupled to the other item or intervening items may be present. For example, devices are "electrically connected" if a conductive path exists between the devices, even if the path includes one or more intermediate components. As used herein the term "and/or" includes any and all combinations of one or more of the associated listed items.

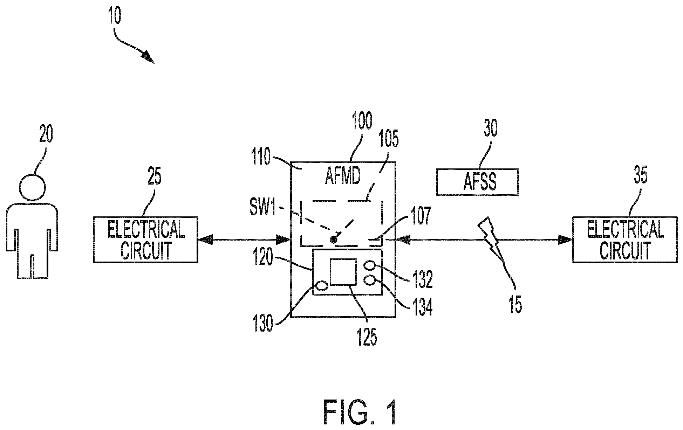

FIG. 1 illustrates a block diagram of a system **10** employing an arc flash mitigation device (AFMD) **100.** Arc flash mitigation device **100** may include a housing **110** with a control panel **120.** Control panel **120** may include a display panel **125** and an indicator **130.** Indicator **130** may include a light indicator including a light emitting diode (LED), another type of light, or some other type of indicator device. By way of non-limiting example, activating arc flash mitigation device **100** may cause the light indicator **130** to illuminate. The light indicator **130** may allow personnel **20** to determine that arc flash mitigation device **100** is armed or "ON."

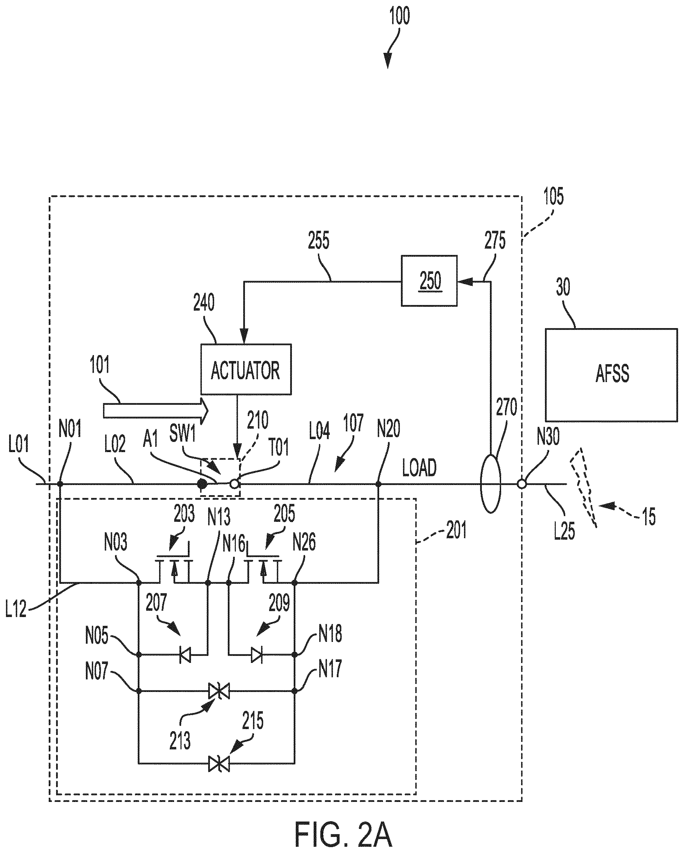

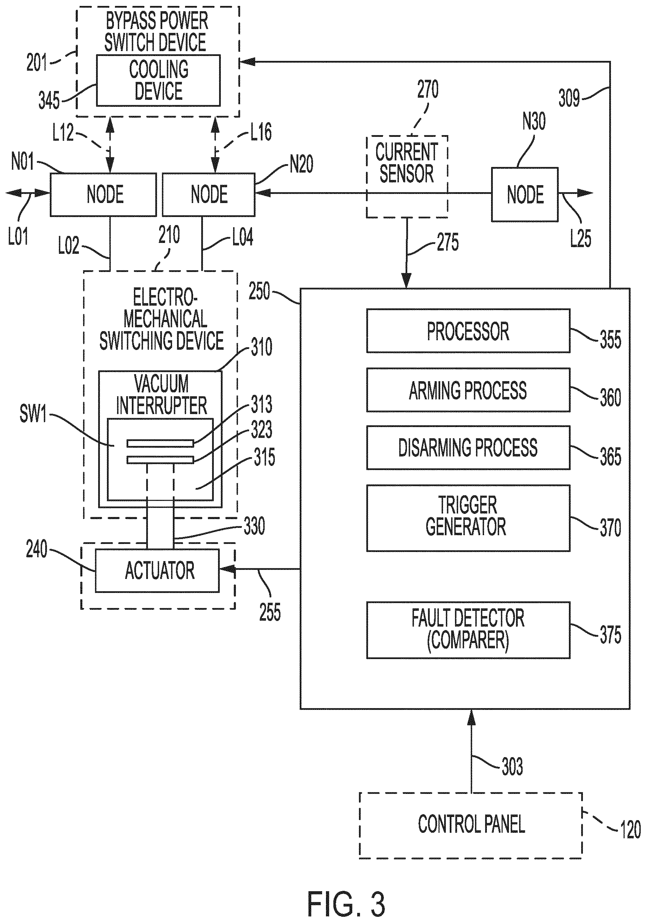

Display panel **125** may include a liquid crystal display (LCD) or LED display. Display panel **125** may include a touch sensitive user interface for receiving user input. Control panel **120** may include control buttons **132** and **134** such as for arming, disarming and/or resetting, respectively, arc flash mitigation device **100.** One or more components of arc flash mitigation device **100** may include a solid-state design. The details of arc flash mitigation device **100** will be described in more detail in relation to FIGS. 2A-2B and 3.

Housing **110** houses protection electronic circuity **105** of arc flash mitigation device **100,** denoted in FIG. 1 as a dashed box. Protection electronic circuity **105** may include a path of least resistance **107.** In FIG. 1, path of least resistance **107** includes an electro-mechanical switch **SW1,** which will be described in more detail in relation to FIGS. 2A-2B. In FIG. 1, switch **SW1** is "OPEN" forming an open-circuit condition within protection electronic circuity **105** along the path of least resistance **107** when arc flash mitigation device **100** is activated or armed.

The system **10** may include an electrical circuit **35** that from time to time requires maintenance by personnel **20.** Electrical circuit **35** may be a sub-component of an electrical power machine or an element of electrical distribution equipment. For example, the machine or equipment may include switchgear, a switchboard or a panelboard. Electrical circuit **35** may include an electrical power circuit. Personnel **20** may be required to connect an electrical circuit **25,** such as an electrical tester or other device electrically to the electrical circuit **35** to perform a test or the other maintenance action. The electrical circuit **25** may generate an electrical current representative of a test signal. The electrical circuit **25** may expect a response or return signal from electrical circuit **35.** As will be described in more detail below, arc flash mitigation device **100** when activated is configured to protect personnel **20.**

In various embodiments, the system **10** may include an arc flash sensor system (AFSS) **30** that is configured to sense an arc flash event downstream of the arc flash mitigation device **100** such as a flash of light **15** or a current representative of an arc flash. Arc flash sensor system **30** may include a vision system with one or more optical sensors, such as cameras or other image capture devices that can detect a flash of light **15.** However, for the purposes of discussion, arc flash sensor system **30** is separate from arc flash mitigation device **100** and may be used to protect other equipment including electrical circuit **35.** Arc flash sensor system **30** may include current sensors of an Arcflash Reduction Maintenance System^{™} (ARMS) by Eaton^{®} Corporation, or other suitable current sensors.

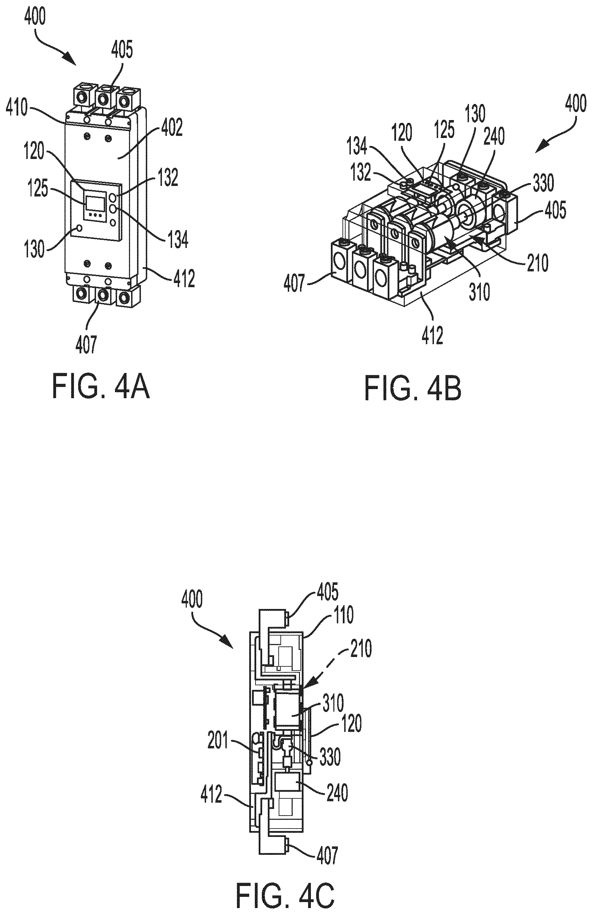

Housing **110** may include a form factor substantially similar to that of a circuit breaker, as will be described later in relation to FIGS. 4A-4C. Housing **110** may have a molded case. Packaging for arc flash mitigation device **100** in such a housing may find particularly advantageous application in providing arc fault mitigation in an electrical panelboard or other equipment at a location suited for installation of a standard form factor breaker. However, it should be understood, that the embodiments are not limited to such a form factor.

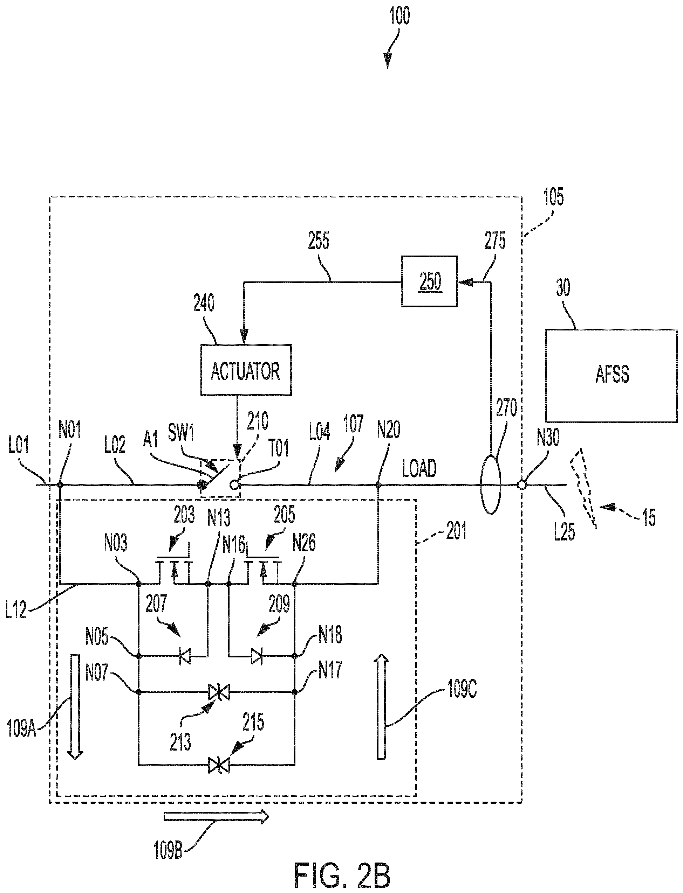

FIG. 2A illustrates a schematic diagram of arc flash mitigation device **100** in a first mode of operation according to some embodiments. The first mode corresponds to a disarmed mode or normal mode of operation of protection electronic circuity **105** with electro-mechanical switch **SW1** "CLOSED" or in a closed-circuit condition. Switch **SW1** is configured to have a lower on-resistance along the path of least resistance **107.** FIG. 2B illustrates a schematic diagram of arc flash mitigation device **100** in a second mode of operation in according to some embodiments. The second mode corresponds to an armed mode or an arc flash reduction maintenance mode of protection electronic circuity **105** with electro-mechanical switch **SW1** "OPEN" or in an open-circuit condition, such that an open-circuit is formed along the path of least resistance **107;** and an alternate bi-directional bypass path through an electronic bi-directional bypass power switch device **201** to vacuum interrupter **310** of the electro-mechanical switching device **210** is created. The electro-mechanical switching device **210** is described in more detail in relation to FIG. 3. The path of least resistance **107** when switch **SW1** is "CLOSED" may be bi-directional.

FIGS. 2A and 2B illustrate the same arc flash mitigation device **100** in different modes of operation, hence like reference numerals are used in these figures.

Bi-directional bypass power switch device **201** may include a solid-state circuit interrupter to interrupt a fault current of a fault event. A fault event may be one of a high-current event or a current representative of an arc flash event. In particular, bypass power switch device **201** is electrically connected to a controller **250.** The controller **250** may send a trigger signal on trigger conductor **255** to activate an ultra-fast actuator **240** connected to the electro-mechanical switching device **210,** in response to an arc flash event or high current, to cause the switch **SW1** to "OPEN." Ultra-fast actuator **240** will be ultra-fast in that is capable of acting more quickly than branch breakers and/or a main breaker of a system. For example, the switch **SW1** may include contacts **313** and **323** (FIG. 3) of the electro-mechanical switching device **210** that will be forced to separate (open) to at least 1 millimeter (mm) distance within a few hundred microseconds (µs) driven by the ultra-fast actuator **240,** as will be described in more detail in relation to FIG. 3.

The controller **250** may be responsive to a fault signal (i.e., high current) from current sensor **270** in-line of the path of least resistance **107** between switch **SW1** and output node **N30.** The current sensor **270** senses current on line **L25,** for example, flowing to node **N30.** The term "node" as used herein may refer to a connection or a connection location.

Responsive to detection of a current level representative of an occurrence of a fault event such as a high-current event or a current associated with an arc flash event, controller **250** generates the trigger signal on trigger conductor **255** to trigger the ultra-fast actuator **240.** The arc flash event corresponds to the presence of an arc flash light **15.** The current sensor **270** may detect current along the path of least resistance **107** or upstream of the arc flash mitigation device **100** and be triggered by a current level that exceeds a threshold that corresponds to a high risk to maintenance personnel or equipment. Using signals from the current sensor **270** and the optical sensors, it may take about 2 ms to detect and confirm via the arc flash sensor system **30** and controller **250** the arc flash event, which will send a trigger signal to the electro-mechanical switching device **210.** Within approximately 2.5 ms, the fault current of the fault event can be interrupted by the arc flash mitigation device **100.**

Circuit breakers, sometimes referred to as circuit interrupters, include electrical contacts that connect to each other to pass current from a source to a load. The contacts may be separated by force in order to interrupt the delivery of current, either in response to a command or to protect electrical systems from electrical fault conditions such as current overloads, short circuits, and high or low voltage conditions. In some embodiments, electro-mechanical switching device **210** may be coupled to an ultra-fast actuator **240** that creates a force to separate the contacts **313** and **323,** as will be described in relation to FIG. 3. An ultra-fast actuator **240** (FIG. 3) will be configured to open the switch **SW1** to achieve at least 1 millimeter (mm) contact gap between the contacts **313** and **323** within a response time within 0.5 ms. Electro-mechanical switching device **210** will be described in more detail in relation to FIG. 3.

As a point of reference, assume that node **N01** on the path of least resistance **107** is an input node that is configured to receive an electrical current from an external electrical circuit **25,** for example. The path of least resistance **107** may begin with node **N01.** Hence, node **N01** may also be referred to as an "input" or "path input." The electrical current at node **N01** may propagate along line **L02** and to electro-mechanical switching device **210** with a switch **SW1.** As the electrical current propagates through switch **SW1,** the electrical current propagates along line **L04** to node **N20,** for example. Switch **SW1** includes an output terminal **T01.** In the closed-circuit condition, representative switching arm **A1** of switch **SW1** is oriented so that an electrical current flowing on line **L02** passes through switch **SW1** to line **L04** also part of the path of least resistance **107.** The switch arm **A1** is for illustrative purposes and not meant to limit the configuration or operation of the switch **SW1** in any way. The path of least resistance **107** continues from node **N20** to the output at node **N30.** Node **N20** may provide a bypass path from node **N01** on an input side of switch **SW1** to an output side of switch **SW1** corresponding to node **N20** in the path of output terminal **T01.** The output side of switch **SW1** corresponds to output terminal **T01** positioned in-line with the path of least resistance **107.**

The electronic bi-directional bypass power switch device **201,** denoted in a dashed box positioned below the path of least resistance **107,** is configured to interrupt the fault current of the fault event, such as from an arc flash event. From node **N01,** the electrical current may propagate in the direction of arrow **109A** to bi-directional bypass power switch device **201** along line **L12** to node **N03,** such as when switch **SW1** is "OPEN." Alternately, the electrical current on line **L12** may propagate to a switch **203** of the bi-directional bypass power switch device **201** in the direction of arrow **109B.** Switch **203** may include a transistor such as a Metal Oxide Field Effect Transistor (MOSFET). The drain side of switch **203** may be connected to node **N03.** The source side of the switch **203** may be connected to node **N13** where a first side of a diode **207** is connected to node **N13** or the source side of the switch **203.** The drain side of the switch **203** may be connected to a second side of diode **207** via node **N05.** In the illustration, the drain side of switch **203** is connected to the cathode of the diode **207;** and the source side of the switch **203** is connected to the anode of diode **207.** While the description herein uses MOSFET devices, other semiconductor transistor switch configurations may be used.

The source side of switch **203** may be electrically connected to a source side of switch **205** via node **N16** in series with node **N13.** Switch **205** may include a transistor such as a Metal Oxide Field Effect Transistor (MOSFET). The drain side of switch **205** may be electrically connected to node **N26** that propagates a signal in the direction of arrow **109C** to node **N20** on the path of least resistance **107.** The MOSFET (transistor) switches **203** and **205** may form a bi-directional switch. The source side of switch **205** may be electrically connected to node **N16** where a first side of a diode **209** is electrically connected to node **N16** or the source side of switch **205.** The drain side of the switch **205** may be electrically connected to a second side of diode **209** via node **N18.** In the illustration, the drain side of switch **205** is electrically connected to the cathode of diode **209;** and the source side of switch **205** is electrically connected to the anode of diode **209.** Since bypass power switch device **201** is bi-directional, the current may flow in the reverse direction such as from node **N20** through arrows **109C, 109B** and **109A** to node **N01,** such as when switch **SW1** is "OPEN."

Bi-directional bypass power switch device **201** may include a first transient-voltage suppression (TVS) diode **213** having one side connected to node **N07** and a second side connected to node **N17.** Node **N17** is electrically connected to node **N18.** Bi-directional bypass power switch device **201** may include a second transient-voltage suppression (TVS) diode **215** also having one side connected to node **N07** and a second side connected to node **N17.** Diodes **213** and **215** may be parallel.

Current sensor **270** is downstream of switch **SW1** in proximity to the node **N30,** which is sometimes referred to as the "output" or "path output." Current sensor **270** is configured to sense an amount of current on line **L25.** Current sensor **270** is in electronic communication with or electrically connected to controller **250** and may deliver a sensed current signal on line **275** representative of a measure of electric current on line **L25.** In other variations, the sensed current signal may produce a fault detection signal, which is communicated to the controller **250** when the sensed signal is at a predefined current threshold to cause injury to personnel **20.**

FIG. 3 illustrates a block diagram of a controller **250** of the arc flash mitigation device **100** of FIGS. 2A-2B interfaced with components of the device. Controller **250** is in electrical communication or connected with control panel **120** to receive a first control signal on line **303.** For example, personnel **20** may place arc flash mitigation device **100** in the normal mode of operation in response to the first control signal generated by control panel **120.** The normal mode of operation corresponds to the arc flash reduction maintenance mode being "OFF," thus the controller **250** sets the switch **SW1** to the closed-circuit condition. Controller **250** may be responsive to control buttons **132** and **134** such as for arming and disarming, respectively, the arc flash mitigation device **100.** Arming the arc flash mitigation device **100** turns "ON" the arc flash reduction maintenance mode such that the switch **SW1** is set in the open-circuit condition.

Control panel **120** may generate the first control signal on line **303** to cause controller **250** to control the operational mode of device **100.** The line **303** may be connected to a control panel input or port of controller **250.** The signals received on the control panel input or port of controller **250** controls the operation (arm process or disarm process) of the controller. Thus, the control panel may generate disarming control signal to disarm device **100** and an arming control signal to arm arc flash mitigation device **100.** Controller **250** may be powered although device **100** is disarmed, as the disarmed mode generally changes the condition of the switch **SW1.**

Specifically, for the normal mode of operation, the controller **250** may cause switch **SW1** to transition to the closed-circuit condition as shown in FIG. 2A, represented as switch arm **A1** connected to output terminal **T01.** Accordingly, the path of least resistance **107** extends from node **N01** to node **N30** without an open-circuit condition. Controller **250** may send control signals in some embodiments on control line **309** to control bypass power switch device **201** to switch to "OFF." Furthermore, controller **250** may control active cooling device **345** of the bypass power switch device **201,** if present. Control panel **120** may generate a second control signal on line **303** to cause controller **250** to control the operational mode of device **100** to cause switch **SW1** to "OPEN," as best seen in FIG. 2B, such that device **100** becomes armed. In other words, the switch **SW1** has an open-circuit condition represented as switch arm A1 being lifted in a direction away from terminal **T01.**

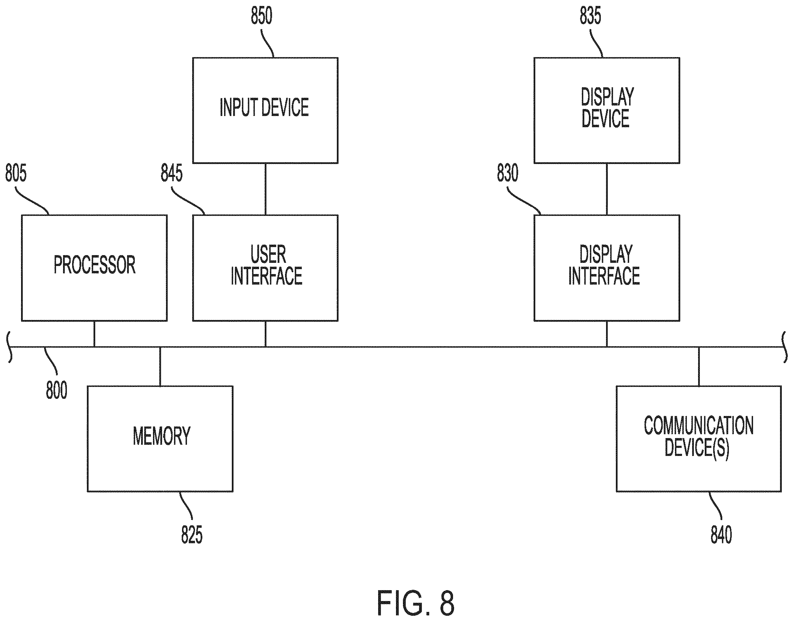

Controller **250** may include at least one processor **355.** Hardware details of controller **250** will be described in more detail in relation to FIG. 8. Controller **250** may also include hardware, software and/or firmware for performing an arming process **360** and a disarming process **365.** The disarming process **365** configures arc flash mitigation device **100** to operate according to the normal mode of operation, as shown in FIG. 2A and described above. For example, the disarming process **365** may cause controller **250** to control switch **SW1** to "CLOSE" or transition to a closed-circuit condition in response to the control signal on line 303.

The disarming process may cause the arc flash reduction maintenance mode to be switched "OFF." Additionally, switch **SW1** may be set to be in a "CLOSE" position and the bypass power switch device **201** can be either in an "OFF" state or in an "ON" state. In various embodiments, the bypass power switch device **201** may remain in an "ON" state when the arc flash reduction maintenance mode is "OFF."

Arming process **360** may cause controller **250** to control switch **SW1** to "OPEN" or transition to an open-circuit condition relative to the path of least resistance **107** in response to a second control signal on line **303.** Switch **SW1** when "OPEN" relative to the path of least resistance **107,** is represented as switch arm **A1** lifted away from contact output terminal **T01.** Switch **SW1** has a low on-resistance. Arming process **360** may also cause controller **250** to set or reset ultra-fast actuator **240** and may cause the arc flash reduction maintenance mode to be turned "ON." In some embodiments, the arming process **360** may engage switch **SW1** which may be part of a vacuum interrupter **310,** in some embodiments, to cause contacts **313** and **323** to separate from each other or open the switch **SW1.** The vacuum interrupter **310** may include a vacuum chamber **315** such as in a ceramic bottle, where an arc is drawn by separating contacts **313** and **323** while carrying current. When actuator **240** is reset, linkage **330** and actuator **240** are configured to maintain contacts **313** and **323** electrically open. Device **100** is also capable of reuse under control of controller **250** after an arc flash event is detected and cleared.

Electro-mechanical switching device **210** when "OPEN" allows the fault current of the fault event to commutate to the bypass power switch device **201** in the current path of the electric circuit **35** downstream. The current commutation can happen either by using a high frequency electronic oscillation circuit (not shown) or by an arc voltage across the contact gap between contacts **313** and **323** when the contacts **313** and **323** separate while carrying current. The fault event or fault current is fully commutated to the power electronic current path through bypass power switch device **201** within tens of microseconds. The contacts **313** and **323** are forced to reach the minimum contact gap to withstand a transient recovery voltage (TRV). Thus, the fault current will be interrupted by bypass power switch device **201** and stop or eliminate the arc flash event or fault current event. All this (e.g., opening the switch **SW1** and interrupting the fault current of the fault event by the bypass power switch device **201**) is configured to happen within about 0.5 ms or less. In other words, the response time is approximately 0.5 ms or less.

Controller **250** may also include a trigger generator **370** and a comparer **375,** which may include hardware, software and/or firmware. While arc flash mitigation device **100** is armed, comparer **375** may compare the signal received from the sensor **270.** The signal on line **275** may be connected to a sensor input or port of controller **250.** Depending on the results of the comparison, trigger generator **370** may generate a trigger signal propagated along trigger conductor **255** to electro-mechanical switching device **210.** Specifically, the trigger signal may be communicated to ultra-fast actuator **240** to activate the actuator to cause the vacuum interrupter **310** to "OPEN" such that the electrical contacts **313** and **323** are forced open by linkage **330.** In FIG. 3, the contact **313** and **323** are shown as open.

In various embodiments, when the switch **SW1** is "CLOSED" and the bypass power switch device **201** is in the "ON" state, for example, controller **250,** although disarmed from the arc flash reduction maintenance mode, is still operational to trigger the actuator **240** to cause switch SW1 to "OPEN," in response to a fault event detected by fault detector (comparer) **375.** Accordingly, when switch **SW1** is "OPEN," the current of the fault event is commutated to the bypass power switch device **201** so that the fault event may be interrupted by the bypass power switch device **201.**

In some scenarios, the signal received by controller **250** from sensor **270** may be a fault signal representative of an arc flash event. The sensor **270** may send a measurement signal representative of the arc flash event or alternately a high-current event. A high-current event is associated with a high current that may be less than the current associated with an arc flash event. The fault signal and measurement signal may be configured to represent an overcurrent or overvoltage condition due to the detected one of the arc flash event and/or the high-current event by the sensor **270.** In some embodiments, comparer **375** of controller **250** may compare the measurement signal with a threshold to detect the occurrence of the arc flash event. In either scenario, comparer **375** may provide a control signal to the trigger generator **370** to cause a trigger signal to be generated.

In some embodiments, ultra-fast actuator **240** may include a Thompson coil actuator connected to linkage **330.** The actuator 240 may be a piezo-electric actuator or other ultra-fast actuator. In operation, ultra-fast actuator **240** may receive a control (trigger) signal from controller **250** to cause the actuator **240** to activate. Actuator **240** when activated produces a fast acting force to be applied on linkage **330** that in turn makes contacts **313** and **323** of switch **SW1** in vacuum interrupter **310** to separate.

Bypass power switch device **201** may have a cooling device **345** that is configured to perform passive cooling or active cooling. In embodiments where the cooling device **345** performs active cooling, fans may be used for cooling. For passive cooling, the cooling device **345** may include a heat sink. When fans are used and the arc flash mitigation device **100** is armed or when the bypass power switch device **201** is set to "ON," the active cooling devices are also turned "ON," as well. Controller **250** may provide additional control signals to electro-mechanical switching device **210** and bypass power switch device **201.**

If implemented in software, the functions of controller **250** may be stored as one or more instructions or code on a computer-readable medium and executed by a hardware-based processing unit. Computer-readable media corresponds to a tangible medium such as data storage media (e.g., RAM, ROM, EEPROM, flash memory, or any other medium that can be used to store desired program code in the form of instructions or data structures and that can be accessed by a computer).

Instructions may be executed by one or more processors **355,** such as one or more digital signal processors (DSPs), general-purpose microprocessors, application specific integrated circuits (ASICs), field programmable logic arrays (FPGAs), or other equivalent integrated or discrete logic circuitry. Accordingly, the term "processor" as used herein may refer to any of the foregoing structure or any other physical structure suitable for implementation of the described techniques. In addition, the techniques could be fully implemented in one or more circuits or logic elements.

Specifically, path of least resistance **107** has a first resistance. Switch **SW1** has a low on-resistance Switch **SW1** has a closed position to output terminal **T01.** A path of least resistance **107** has an input (i.e., node **N01**) and an output (i.e., node **N30**) with switch **SW1** between the input (i.e., node **N01**) and output (i.e., node **N30**). Electro-mechanical switching device **210** has an open-circuit condition when the switch **SW1** is in an open position. The bi-directional bypass power switch device **201** is electrically connected to the path of least resistance **107** at a first location associated with the input (i.e., node **N01**) and at a second location between the switch **SW1** and the output (i.e., node **N30**).

When the bi-directional bypass power switch device **201** is "ON" and switch **SW1** is "OPEN," the bypass power switch device **201** is configured to carry an electrical current originating at node **N01** or the input to node **N30** or the output. The bi-directional bypass power switch device **201** is also configured to conduct an electrical current originating at node **N30** or the output to node **N01** or the input. In the scenario that a fault event is experienced when the arc flash reduction maintenance mode is "ON," bi-directional bypass power switch device **201** protects maintenance personnel by interrupting the fault current of the fault event including an arc flash event. In particular, parallel transient-voltage suppression (TVS) diodes **213** and **215** may be configured to limit transient overvoltage level. Alternately, any current from line **L25** to node **N20** may go through bi-directional bypass power switch device **201.**

When bi-directional bypass power switch device **201** is "ON" and switch **SW1** is "CLOSED," controller **250** is configured to, in response to receiving a signal representative of a fault event, generate a trigger signal to actuator **240** to interrupt a fault current of an arc flash event or high-current fault event by opening switch **SW1.** Thus, the fault current of the fault event is interrupted by bypassing a portion of the path of least resistance and channeling the fault current at node **N20** to bi-directional bypass power switch device **201.** Again, any current from line **L25** to node **N20** may be propagated through bi-directional bypass power switch device **201** and interrupted so that the fault event is stopped.

If the arc flash reduction maintenance mode is turned on in which switch SW1 is already "OPEN", for example, then when the fault current reaches 2X or 2.5X the rated current, the bi-directional power electronic switch **201** will interrupt the fault current within 100 µs. The arc flash energy is associated with the arc flash event and may be described as the fault current multiplied by the arc voltage.

The solid-state design can be packaged into the same form factor as a molded case circuit breaker (MCCB) or an air circuit breaker (ACB) so that it retrofit in existing switchgear, switchboard or panelboard, for example, as will be discussed in relation to FIGS. 4A-4C, 6A-6B and 7.

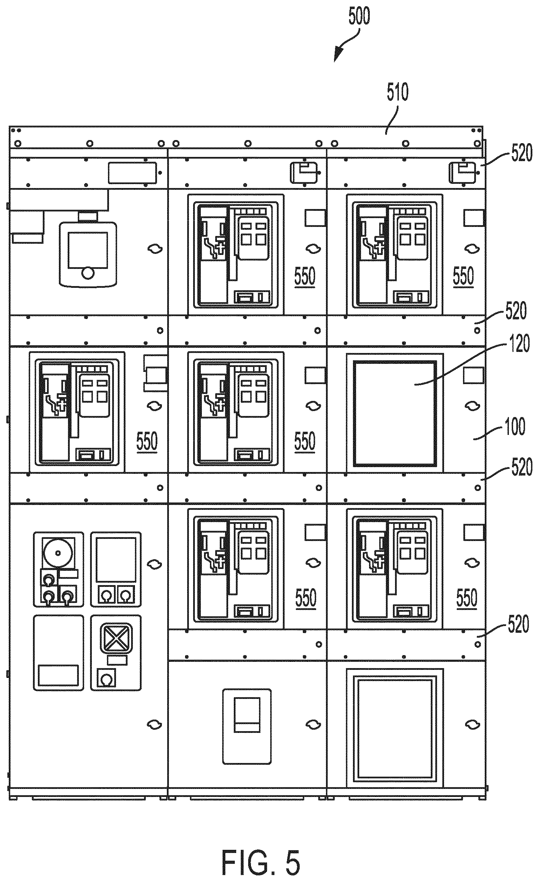

FIG. 4A illustrates a front perspective view of an arc flash mitigation device **400** with a housing with a MCCB form factor. Arc flash mitigation device **400** is the same as arc flash mitigation device **100** except details of the form factor of housing **410** will be described. Housing **410** may include upper connectors **405** and lower connectors **407** for attaching cables or bus bars to conduct current from line side to load side electrical equipment, for example, or other electrical machine. A front panel or cover **402** of the housing **410** may have display panel **125,** indicator **130** and control buttons **132** and **134** for easy access by personnel **20** (FIG. 1). However, it should be understood that control panel **120** may include other control buttons not described. FIG. 4B illustrates an end and side perspective view of the arc flash mitigation device **400** of FIG. 4A with a portion of the housing removed. FIG. 4C illustrates a side view of the arc flash mitigation device **400** of FIG. 4A with a portion of the housing removed. A back panel **412** may be mated and attached to a panel inside of switchgear **500** (FIG. 5) Housing **410** may locate bi-directional bypass power switch device **201** of protection electronic circuity **105** adjacent a back panel **412** of housing **410.** Electro-mechanical switching device **210** may include a vacuum interrupter **310.** The ultra-fast actuator **240** is mechanically coupled to the vacuum interrupter **310** via a linkage **330.** Electro-mechanical switching device **210** may have one end coupled to a top end of housing **410.** Arc flash mitigation device **400** may include a plurality of electro-mechanical switching devices **210** arranged in parallel for different poles. Each electro-mechanical switching device **210** is connected to its own actuator **240** via a linkage **330.**

FIG. 5 illustrates an example electrical switchgear **500** to which an arc mitigation device may be installed according to some embodiments. A switchgear **500** may be configured to receive a standard form circuit breaker. The switchgear **500** includes a housing **510** for housing a bus backplane assembly **520** mounted to the housing **510.** The bus backplane assembly **520** may be configured to receive a circuit breaker, which may be electrically connected to buses of the bus backplane assembly **520** and arc flash mitigation device **100** housed in a housing with a compatible form factor and includes control panel **120.**

Housing **510** may include cutouts sized to expose a front face of circuit breakers **550** installed in the bus backplane assembly **520.** As illustrated, according to some embodiments, an arc mitigation device **100** having a form factor substantially the same as a circuit breaker **550** may be installed in the switchgear **500,** instead of a circuit breaker. The switchgear **500** is shown with cutouts of various sizes to accommodate other electronic devices.

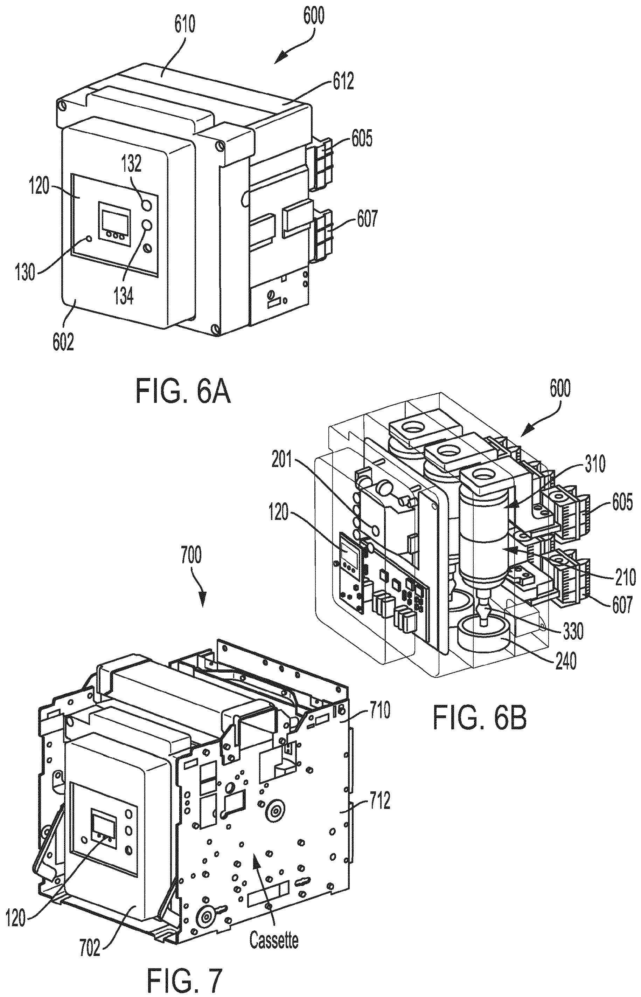

FIG. 6A illustrates a front perspective view of an arc flash mitigation device **600** with a housing with an air circuit breaker (ACB) form factor. Arc flash mitigation device **600** is the same, as arc flash mitigation device **100** except details of the form factor of housing **610** will be described. A front panel or cover **602** of the housing **610** may have mounted display panel **125,** indicator **130** and control buttons **132** and **134** of the control panel **120** for easy access by personnel **20** (FIG. 1). Housing **610** may include a rear housing section **612** that is configured to be mated and attached to the front panel or cover **602.** The rear housing section **612** may have mounted on a rear surface rear upper connectors **605** and rear lower connectors **607** for attaching housing **610** to bus bar connectors to conduct current from its line side to load side to downstream electrical equipment (FIG. 5), for example, or other electrical machine. FIG. 6B illustrates a front perspective view of the arc flash mitigation device **600** of FIG. 6A with a portion of the housing removed. The housing **610** may locate bi-directional bypass power switch device **201** of protection electronic circuity **105** adjacent front panel **602** of housing **610.** Electro-mechanical switching device **210** may include a vacuum interrupter **310** mechanically connected to a lower mounted ultra-fast actuator **240** via a linkage **330.**

FIG. 7 illustrates a front perspective view of an arc flash mitigation device **700** with a housing with a cassette form factor. Arc flash mitigation device **700** is the same, as arc flash mitigation device **100** except details of the form factor of housing **710** will be described. A front panel or cover **702** of the housing **710** may have mounted display panel **125,** indicator **130** and control buttons **132** and **134** of the control panel **120** for easy access by personnel **20** (FIG. 1). Housing **710** may include a rear housing section **7.12** that is configured to be mated and attached to the front panel or cover **702.**

FIG. 8 depicts an example of internal hardware that may be included in any of the electronic components of the system, such as controllers, sensors and computing devices. An electrical bus **800** serves as an information highway interconnecting the other illustrated components of the hardware. Processor **805** is a central processing device of the system, configured to perform calculations and logic operations required to execute programming instructions. As used in this document and in the claims, the terms "processor" and "processing device" may refer to a single processor or any number of processors in a set of processors that collectively perform a set of operations, such as a central processing unit (CPU), a remote server, or a combination of these. Read only memory (ROM), random access memory (RAM), flash memory, hard drives and other devices capable of storing electronic data constitute examples of memory devices **825.** A memory device **825** may include a single device or a collection of devices across which data and/or instructions are stored. Various embodiments of the invention may include a computer-readable medium containing programming instructions that are configured to cause one or more processors, print devices and/or scanning devices to perform the functions described in the context of the previous figures.

An optional display interface **830** may permit information from bus **800** to be displayed on a display device **835** (i.e., control panel) in visual, graphic or alphanumeric format. An audio interface and audio output (such as a speaker) also may be provided. Communication with external devices may occur using various communication devices **840** such as a wireless antenna, a radio frequency identification (RFID) tag and/or short-range or near-field communication transceiver, each of which may optionally communicatively connect with other components of the device via one or more communication system. Communication device(s) **840** may be configured to be communicatively connected to a communications network, such as the Internet, a local area network or a cellular telephone data network.

The hardware may also include a user interface sensor **845** that allows for receipt of data from input devices **850** such as a keyboard or keypad, a joystick, a touchscreen, a touch pad, a remote control, control buttons, a pointing device and/or microphone.

Terminology that is relevant to the disclosure provided above includes:

The terms "memory" and "computer-readable medium" each refer to a nontransitory device on which computer-readable data, programming instructions or both are stored. Except where specifically stated otherwise, the terms "memory" and "computer-readable media" are intended to include single device embodiments, embodiments in which multiple memory devices together or collectively store a set of data or instructions, as well as individual sectors within such devices.

The terms "processor" and "processing device" refer to a hardware component of an electronic device that is configured to execute programming instructions. Except where specifically stated otherwise, the terms "memory" and "computer-readable medium" are intended to include single-processing device embodiments and embodiments in which multiple processing devices together or collectively perform a process.

In this document, the term "communication line" means a wired or wireless path via which a first device sends communication signals to and/or receives communication signals from one or more other devices. Devices are "communicatively connected" if the devices are able to send and/or receive data via a communication link. "Electronic communication" refers to the transmission of data via one or more signals between two or more electronic devices, whether through a wired or wireless network, and whether directly or indirectly via one or more intermediary devices.

In this document, when relative terms of order such as "first" and "second" are used to modify a noun, such use is simply intended to distinguish one item from another, and is not intended to require a sequential order unless specifically stated.

In addition, terms of relative position such as "vertical" and "horizontal", or "front" and "rear", when used, are intended to be relative to each other and need not be absolute, and only refer to one possible position of the device associated with those terms depending on the device's orientation. In addition, the terms "front" and "rear" are not necessarily limited to forward-facing or rear-facing areas but also include side areas that are closer to the front than the rear, or vice versa, respectively.

## Claims

1. A device comprising:
an electro-mechanical switching device (210) having an open-circuit condition and a closed-circuit condition, the electro-mechanical switching device comprising an electro-mechanical switch (SW1) actuatable between an open state corresponding to the open-circuit condition and a closed state corresponding to the closed-circuit condition;
a path of least resistance (107) having a path input (N01) and a path output (N30) with the electro-mechanical switching device (210) between the path input (N01) and the path output (N30);
a bypass power switch device (201) that comprises a solid-state circuit interrupter and that is configured to conduct current between the path input (N01) and the path output (N30) in response to an open-circuit condition of the electro-mechanical switching device (210), the solid-state circuit interrupter comprising a first transistor (203) and a second transistor (205);
a current sensor (270) that is connected to the path output (N30), the current sensor is configured to detect a fault current event;
an actuator (240) that is coupled to the electro-mechanical switching device (210); and
a controller (250) that is configured to generate a trigger signal to activate the actuator (240) to cause the open-circuit condition of the electro-mechanical switching device (210) and to interrupt the fault current event by the bypass power switch device (201), based on the detected fault current event,
**characterized in that**:
the electro-mechanical switch (SW1) is the only switch connected between the path input (N01) and the path output (N30) in the path of least resistance (107), the bypass power switch (201) is connected to the path of least resistance (107) at a first node and a second node (N20), the first node being at the path input (N01), the second node being disposed between the electro-mechanical switching device (210) and the path output (N30),
interrupting the fault current event by the bypass power switch device (201) comprises channeling current at the second node (N20) to the bypass power switch device (201) in order to bypass a portion of the path of least resistance (107), and
the first transistor (203) and the second transistor (205) are configured to complete interruption of the fault current event.

2. The device of claim 1, wherein:
the current sensor (270) has an output that is connected to a sensor input of the controller (250); and
the current sensor (270) is configured to communicate a signal representative of detection of the fault current event to the sensor input of the controller (250).

3. The device of claim 1, further comprising an external control panel connected to a control panel input of the controller,
wherein the external control panel is configured to provide a user interface to control operations of the controller.

4. The device of claim 3, wherein the controller (250) is also configured to:
in response to receiving a disarming control signal at the control panel input, cause in the path of least resistance (107) the closed-circuit condition of the electro-mechanical switching device (210); and
in response to receiving an arming control signal at the control panel input, cause in the path of least resistance (107) the open-circuit condition of the electro-mechanical switching device (210).

5. The device of claim 1, wherein the solid-state circuit interrupter comprises:
at least one transient-voltage suppression (TVS) diode (213, 215) having a first end connected to the path input and a second end connected to the path of least resistance (107) between the electro-mechanical switching device (210) and the path output (N30); and
a bi-directional transistor switch having a first connection connected to the first end and the path input and a second connection connected to the second end and the path output (N30).

6. The device of claim 5, wherein the at least one TVS diode comprises parallel TVS diodes (213, 215).

7. The device of claim 1, further comprising:
a housing (110; 410) for housing the electro-mechanical switching device (210), the path of least resistance (107), the bypass power switch device (201) and the controller (250),
wherein the housing (110; 410) comprises a molded case circuit breaker or an air circuit breaker.

8. The device of claim 1, wherein:
the electro-mechanical switching device (210) comprises a vacuum interrupter (310); and
the actuator (240) comprises a Thompson coil or piezo-electric actuator connected to the vacuum interrupter (310).

9. The device of claim 1, wherein the bypass power switch device (201) also comprises a cooling device (345).

10. The device of claim 9, wherein the detected fault current event comprises a current associated with an arc flash event.

11. A method comprising:
controlling, in a path of least resistance (107) including a path input and a path output (N30), an electro-mechanical switching device (210) that is between the path input and the path output, the electro-mechanical switching device (210) comprising an electro-mechanical switch (SW1);
detecting, by a current sensor (270), a fault current event at the path output (N30);
generating, by a controller (250), a trigger signal to activate an actuator (240) coupled to the electro-mechanical switching device (210);
causing an open-circuit condition of the electro-mechanical switching device (210) in the path of least resistance (107), in response to the activation of the actuator (240); and
interrupting the detected fault current event by a bypass power switch device (201) that comprises a solid-state circuit interrupter connected to the path input and
the path output (N30), in response to the open-circuit condition, the solid-state circuit interrupter comprising a first transistor (203) and a second transistor (205),
**characterized in that**:
the electro-mechanical switch (SW1) is the only switch connected between the path input and the path output (N30) in the path of least resistance,
the bypass power switch device (201) is connected to the path input at a first node (N01) and to the path output (N30) at a second node (N20), the second node being disposed between the electro-mechanical switching device (210) and the path output (N30), interrupting the fault current event by the bypass power switch device (201) comprises channeling current at the second node (N20) to the bypass power switch device (201) in order to bypass a portion of the path of least resistance (107), and
the first transistor (203) and the second transistor (205) are configured to complete interruption of the fault current event.

12. The method of claim 11, wherein the fault current event comprises an arc flash event that occurred downstream the path output (N30).

13. The method of claim 11, further comprising controlling, by an external control panel connected to a control panel input of the controller (250), operations of the controller.

14. The method of claim 13, wherein the controlling comprises:
in response to a disarming control signal received at the control panel input of the controller (250), causing a closed-circuit condition of the electro-mechanical switching device (210) from the path input to the path output (N30); and
in response to an arming control signal received at the control panel input of the controller (250), causing the open-circuit condition of the electro-mechanical switching device (210).

15. The method of claim 11, wherein the interrupting by the bypass power switch device (201) comprises:
passing the fault current event to at least one transient-voltage suppression (TVS) diode (213, 215) of the solid-state circuit interrupter connected to the path of least resistance (107) between the electro-mechanical switching device (210) and the path output (N30), to suppress a transient voltage.

## Patentansprüche

1. Vorrichtung, umfassend:
eine elektromechanische Schalteinrichtung (210) mit einem Zustand des offenen Stromkreises und einem Zustand des geschlossenen Stromkreises, wobei die elektromechanische Schalteinrichtung einen elektromechanischen Schalter (SW1) umfasst, der zwischen einem offenen Zustand, welcher dem Zustand des offenen Stromkreises entspricht, und einem geschlossenen Zustand, welcher dem Zustand des geschlossenen Stromkreises entspricht, betätigbar ist;
einen Pfad des geringsten Widerstands (107) mit einem Pfadeingang (N01) und einem Pfadausgang (N30), wobei sich die elektromechanische Schalteinrichtung (210) zwischen dem Pfadeingang (N01) und dem Pfadausgang (N30) befindet;
eine Umgehungs-Leistungsschaltvorrichtung (201), die einen Festkörper-Stromkreisunterbrecher umfasst und dazu ausgebildet ist, in Ansprechen auf einen Zustand des offenen Stromkreises der elektromechanischen Schalteinrichtung (210) Strom zwischen dem Pfadeingang (N01) und dem Pfadausgang (N30) zu leiten, wobei der Festkörper-Stromkreisunterbrecher einen ersten Transistor (203) und einen zweiten Transistor (205) umfasst;
einen Stromsensor (270), der mit dem Pfadausgang (N30) verbunden ist, wobei der Stromsensor dazu ausgebildet ist, ein Fehlerstromereignis zu erfassen;
einen Aktuator (240), der mit der elektromechanischen Schalteinrichtung (210) gekoppellt ist; und
eine Steuerung (250), die dazu ausgebildet ist, basierend auf dem erfassten Fehlerstromereignis ein Auslösesignal zu erzeugen, um den Aktuator (240) zu aktivieren, um den Zustand des offenen Stromkreises der elektromechanischen Schalteinrichtung (210) zu bewirken und das Fehlerstromereignis durch die Umgehungs-Leistungsschaltvorrichtung (201) zu unterbrechen,
**dadurch gekennzeichnet, dass**:
der elektromechanische Schalter (SW1) der einzige Schalter ist, der in dem Pfad des geringsten Widerstands (107) zwischen dem Pfadeingang (N01) und dem Pfadausgang (N30) angeschlossen ist,
die Umgehungs-Leistungsschaltvorrichtung (201) an einem ersten Knoten und einem zweiten Knoten (N20) mit dem Pfad des geringsten Widerstands (107) verbunden ist, wobei sich der erste Knoten am Pfadeingang (N01) befindet und der zweite Knoten zwischen der elektromechanischen Schalteinrichtung (210) und dem Pfadausgang (N30) angeordnet ist,
das Unterbrechen des Fehlerstromereignisses durch die Umgehungs-Leistungsschaltvorrichtung (201) das Leiten von Strom an dem zweiten Knoten (N20) zu der Umgehungs-Leistungsschaltvorrichtung (201) umfasst, um einen Teil des Pfades des geringsten Widerstands (107) zu umgehen, und
der erste Transistor (203) und der zweite Transistor (205) dazu ausgebildet sind, die Unterbrechung des Fehlerstromereignisses zu vervollständigen.

2. Vorrichtung nach Anspruch 1, wobei:
der Stromsensor (270) einen Ausgang aufweist, der mit einem Sensoreingang der Steuerung (250) verbunden ist; und
der Stromsensor (270) dazu ausgebildet ist, ein Signal, das die Erfassung des Fehlerstromereignisses repräsentiert, an den Sensoreingang der Steuerung (250) zu übermitteln.

3. Vorrichtung nach Anspruch 1, ferner umfassend ein externes Bedienfeld, das mit einem Bedienfeld-Eingang der Steuerung verbunden ist,
wobei das externe Bedienfeld dazu ausgebildet ist, eine Benutzerschnittstelle zur Steuerung des Betriebs der Steuerung bereitzustellen.

4. Vorrichtung nach Anspruch 3, wobei die Steuerung (250) ferner dazu ausgebildet ist:
in Ansprechen auf den Empfang eines Entschärfungs-Steuersignals an dem Bedienfeld-Eingang, in dem Pfad des geringsten Widerstands (107) den Zustand des geschlossenen Stromkreises der elektromechanischen Schalteinrichtung (210) zu bewirken; und
in Ansprechen auf den Empfang eines Scharfschallt-Steuersignals an dem Bedienfeld-Eingang, in dem Pfad des geringsten Widerstands (107) den Zustand des offenen Stromkreises der elektromechanischen Schalteinrichtung (210) zu bewirken.

5. Vorrichtung nach Anspruch 1, wobei der Festkörper-Stromkreisunterbrecher umfasst:
mindestens eine Suppressordiode (Transient Voltage Supressor, TVS-Diode) (213, 215) mit einem ersten Ende, das mit dem Pfadeingang verbunden ist, und einem zweiten Ende, das mit dem Pfad des geringsten Widerstands (107) zwischen der elektromechanischen Schalteinrichtung (210) und dem Pfadausgang (N30) verbunden ist; und
einen bidirektionalen Transistorschalter mit einem ersten Anschluss, der mit dem ersten Ende und dem Pfadeingang verbunden ist, und einem zweiten Anschluss, der mit dem zweiten Ende und dem Pfadausgang (N30) verbunden ist.

6. Vorrichtung nach Anspruch 5, wobei die mindestens eine TVS-Diode parallele TVS-Dioden (213, 215) umfasst.

7. Vorrichtung nach Anspruch 1, ferner umfassend:
ein Gehäuse (110; 410) zur Aufnahme der elektromechanischen Schalteinrichtung (210), des Pfades des geringsten Widerstands (107), der Umgehungs-Leistungsschaltvorriichtung (201) und der Steuerung (250),
wobei das Gehäuse (110; 410) einen Kompaktleistungsschallter (Molded Case Circuit Breaker) oder einen Luft-Leistungsschalter (Air Circuit Breaker) umfasst.

8. Vorrichtung nach Anspruch 1, wobei:
die elektromechanische Schalteinrichtung (210) einen Vakuumunterbrecher (310) umfasst; und
der Aktuator (240) eine Thompson-Spule oder einen piezoelektrischen Aktuator umfasst, der mit dem Vakuumunterbrecher (310) verbunden ist.

9. Vorrichtung nach Anspruch 1, wobei die Umgehungs-Leistungsschaltvorrichtung (201) ferner eine Kühlvorrichtung (345) umfasst.

10. Vorrichtung nach Anspruch 9, wobei das erfasste Fehlerstromereignis einen Strom umfasst, der mit einem Störlichtbogenereignis verbunden ist.

11. Verfahren, umfassend:
Steuern, in einem Pfad des geringsten Widerstands (107), der einen Pfadeingang und einen Pfadausgang (N30) umfasst, einer elektromechanischen Schalteinrichtung (210), die sich zwischen dem Pfadeingang und dem Pfadausgang befindet, wobei die elektromechanische Schalteinrichtung (210) einen elektromechanischen Schalter (SW1) umfasst;
Erfassen, durch einen Stromsensor (270), eines Fehlerstromereignisses an dem Pfadausgang (N30);
Erzeugen, durch eine Steuerung (250), eines Auslösesignals, um einen mit der elektromechanischen Schalteinrichtung (210) gekoppelten Aktuator (240) zu aktivieren;
Bewirken eines Zustands eines offenen Stromkreises der elektromechanischen Schalteinrichtung (210) in dem Pfad des geringsten Widerstands (107), in Ansprechen auf die Aktivierung des Aktuators (240); und
Unterbrechen des erfassten Fehlerstromereignisses durch eine Umgehungs-Leistungsschaltvorrichtung (201), die einen mit dem Pfadeingang und dem Pfadausgang (N30) verbundenen Festkörper-Stromkreisunterbrecher umfasst,
in Ansprechen auf den Zustand des offenen Stromkreises, wobei der Festkörper-Stromkreisunterbrecher einen ersten Transistor (203) und einen zweiten Transistor (205) umfasst,
dadurch gelkennzeichnet, dass:
der elektromechanische Schallter (SW1) der einzige Schallter ist, der in dem Pfad des geringsten Widerstands zwischen dem Pfadeingang und dem Pfadausgang (N30) angeschlossen ist,
die Umgehungs-Leistungsschaltvorrichtung (201) an einem ersten Knoten (N01) mit dem Pfadeingang und an einem zweiten Knoten (N20) mit dem Pfadausgang (N30) verbunden ist, wobei der zweite Knoten zwischen der elektromechanischen Schalteinrichtung (210) und dem Pfadausgang (N30) angeordnet ist,
das Unterbrechen des Fehlerstromereignisses durch die Umgehungs-Leistungsschaltvorrichtung (201) das Leiten von Strom an dem zweiten Knoten (N20) zu der Umgehungs-Leistungsschaltvorrichtung (201) umfasst, um einen Teil des Pfades des geringsten Widerstands (107) zu umgehen, und
der erste Transistor (203) und der zweite Transistor (205) dazu ausgebildet sind, die Unterbrechung des Fehlerstromereignisses zu vervollständigen.

12. Verfahren nach Anspruch 11, bei welchem das Fehlerstromereignis ein Störlichtbogenereignis umfasst, das stromabwärts des IPfadausgangs (N30) aufgetreten ist.

13. Verfahren nach Anspruch 11, ferner umfassend das Steuern des Betriebs der Steuerung (250) durch ein externes Bedienfeld, das mit einem Bedienfeld-Eingang der Steuerung (250) verbunden ist.

14. Verfahren nach Anspruch 13, bei welchem das Steuern umfasst:
in Ansprechen auf ein an dem Bedienfeld-Eingang der Steuerung (250) empfangenes Entschälrfungs-Steuersignal, Bewirken eines Zustands des geschlossenen Stromkreises der elektromechanischen Schalteinrichtung (210) von dem Pfadeingang zu dem Pfadausgang (N30); und
in Ansprechen auf ein an dem Bedienfeld-Eingang der Steuerung (250) empfangenes Scharfschalt-Steuersignal, Bewirken des Zustands des offenen Stromkreises der elektromechanischen Schalteinrichtung (210).

15. Verfahren nach Anspruch 11, bei welchem das Unterbrechen durch die Umgehungs-Leistungsschaltvorrichtung (201) umfasst:
Leiten des Fehlerstromereignisses zu mindestens einer Suppressordiode (Transient Voltage Supressor, TVS-Diode) (213, 215) des Festkörper-Stromkreisunterbrechers, die mit dem Pfad des geringsten Widerstands (107) zwischen der elektromechanischen Schalteinrichtung (210) und dem Pfadausgang (N30) verbunden ist, um eine transiente Spannung zu unterdrücken.

## Revendications

1. Dispositif comprenant :
un dispositif de commutation électromécanique (210) présentant un état de circuit ouvert et un état de circuit fermé, le dispositif de commutation électromécanique comprenant un interrupteur électromécanique (SW1) pouvant être actionné entre un état ouvert correspondant à l'état de circuit ouvert et un état fermé correspondant à l'état de circuit fermé ;
un chemin de moindre résistance (107) ayant une entrée de chemin (N01) et une sortie de chemin (N30) avec le dispositif de commutation électromécanique (210) entre l'entrée de chemin (N01) et la sortie de chemin (N30) ; un dispositif interrupteur de puissance de dérivation (201) qui comprend un interrupteur de circuit à semi-conducteur et qui est configuré pour conduire un courant entre l'entrée de chemin (N01) et la sortie de chemin (N30) en réponse à une condition de circuit ouvert du dispositif de commutation électromécanique (210),
l'interrupteur de circuit à semi-conducteur comprenant un premier transistor (203) et un deuxième transistor (205) ;
un capteur de courant (270) connecté à la sortie de chemin (N30), le capteur de courant étant configuré pour détecter un évènement de courant de défaut ;
un actionneur (240) couplé au dispositif de commutation électromécanique (210) ; et
un contrôleur (250) qui est configuré pour générer un signal de déclenchement pour activer l'actionneur (240) afin de provoquer l'état de circuit ouvert du dispositif de commutation électromécanique (210) et pour interrompre l'événement de courant de défaut par le dispositif interrupteur de puissance de dérivation (201), sur la base de l'événement de courant de défaut détecté,
**caractérisé en ce que** :
le commutateur électromécanique (SW1) est le seul commutateur connecté entre l'entrée de chemin (N01) et la sortie de chemin (N30) dans le chemin de moindre résistance (107),
l'interrupteur de puissance de dérivation (201) est connecté au chemin de moindre résistance (107) au niveau d'un premier nœud et d'un deuxième nœud (N20), le premier nœud étant au niveau de l'entrée de chemin (N01), le deuxième nœud étant disposé entre le dispositif de commutation électromécanique (210) et la sortie de chemin (N30),
l'interruption de l'événement de courant de défaut par le dispositif interrupteur de puissance de dérivation (201) comprend l'acheminement du courant au niveau du deuxième nœud (N20) vers le dispositif interrupteur de puissance de dérivation (201) afin de contourner une partie du chemin de moindre résistance (107), et
le premier transistor (203) et le deuxième transistor (205) sont configurés pour achever l'interruption de l'événement de courant de défaut.

2. Dispositif selon la revendication 1, dans lequel :
le capteur de courant (270) a une sortie qui est connectée à une entrée de capteur du contrôleur (250) ; et
le capteur de courant (270) est configuré pour communiquer un signal représentatif de la détection de l'événement de courant de défaut à l'entrée de capteur du contrôleur (250).

3. Dispositif selon la revendication 1, comprenant en outre un panneau de commande externe connecté à une entrée de panneau de commande du contrôleur,
où le panneau de commande externe est configuré pour fournir une interface utilisateur pour commander les opérations du dispositif de commande.

4. Dispositif selon la revendication 3, dans lequel le contrôleur (250) est également configuré pour :
en réponse à la réception d'un signal de commande de désarmement à l'entrée du panneau de commande, provoquer, dans le chemin de moindre résistance (107), l'état de circuit fermé du dispositif de commutation électromécanique (210) ; et
en réponse à la réception d'un signal de commande d'armement au niveau de l'entrée du panneau de commande, provoquer, dans le chemin de moindre résistance (107), l'état de circuit ouvert du dispositif de commutation électromécanique (210).

5. Dispositif selon la revendication 1, dans lequel l'interrupteur de circuit à semi-conducteur comprend :
au moins une diode de suppression de tension transitoire (TVS) (213, 215) ayant une première extrémité connectée à l'entrée de chemin et une deuxième extrémité connectée au chemin de moindre résistance (107) entre le dispositif de commutation électromécanique (210) et la sortie de chemin (N30) ; et
un commutateur à transistor bidirectionnel ayant une première connexion connectée à la première extrémité et à l'entrée de chemin et une deuxième connexion connectée à la deuxième extrémité et à la sortie de chemin (N30).

6. Dispositif selon la revendication 5, dans lequel l'au moins une diode TVS comprend des diodes TVS parallèles (213, 215).

7. Dispositif selon la revendication 1, comprenant en outre :
un logement (110 ; 410) pour loger le dispositif de commutation électromécanique (210), le chemin de moindre résistance (107), le dispositif interrupteur de puissance de dérivation (201) et le contrôleur (250),
où le boîtier (110 ; 410) comprend un disjoncteur à boîtier moulé ou un disjoncteur à air.

8. Dispositif selon la revendication 1, dans lequel :
le dispositif de commutation électromécanique (210) comprend un interrupteur à vide (310) ; et
l'actionneur (240) comprend une bobine Thompson ou un actionneur piézo-électrique connecté à l'interrupteur à vide (310).

9. Dispositif selon la revendication 1, dans lequel le dispositif interrupteur de puissance de dérivation (201) comprend également un dispositif de refroidissement (345).

10. Dispositif selon la revendication 9, dans lequel l'événement de courant de défaut détecté comprend un courant associé à un événement d'arc électrique.

11. Procédé comprenant les étapes suivantes :
commander, dans un chemin de moindre résistance (107) incluant une entrée de chemin et une sortie de chemin (N30), un dispositif de commutation électromécanique (210) qui se trouve entre l'entrée de chemin et la sortie de chemin, le dispositif de commutation électromécanique (210) comprenant un interrupteur électromécanique (SW1) ;
détecter, par un capteur de courant (270), un évènement de courant de défaut à la sortie du chemin (N30) ;
générer, par un contrôleur (250), un signal de déclenchement pour activer un actionneur (240) couplé au dispositif de commutation électromécanique (210) ;
provoquer un état de circuit ouvert du dispositif de commutation électromécanique (210) dans le chemin de moindre résistance (107), en réponse à l'activation de l'actionneur (240) ; et
interrompre l' événement de courant de défaut détecté par un dispositif interrupteur de puissance de dérivation (201) qui comprend un interrupteur de circuit à semi-conducteur connecté à l'entrée de chemin et la sortie de chemin (N30), en réponse à la condition de circuit ouvert, l'interrupteur de circuit à semi-conducteur comprenant un premier transistor (203) et un deuxième transistor (205), **caractérisé en ce que** :
l'interrupteur électromécanique (SW1) est le seul commutateur connecté entre l'entrée de chemin et la sortie de chemin (N30) dans le chemin de moindre résistance,
le dispositif interrupteur de puissance de dérivation (201) est connecté à l'entrée de chemin au niveau d'un premier nœud. (N01) et à la sortie de chemin (N30) au niveau d'un deuxième nœud (N20), le deuxième nœud étant disposé entre le dispositif de commutation électromécanique (210) et la sortie de chemin (N30),
l'interruption de l'événement de courant de défaut par le dispositif interrupteur de puissance de dérivation (201) comprend l'acheminement du courant au niveau du deuxième nœud (N20) vers le dispositif interrupteur de puissance de dérivation (201) afin de contourner une partie du chemin de moindre résistance (107), et
le premier transistor (203) et le deuxième transistor (205) sont configurés pour achever l'interruption de l'événement de courant de défaut.

12. Procédé selon la revendication 11, dans lequel l'événement de courant de défaut comprend un événement d'arc électrique qui s'est produit en aval de la sortie de chemin (N30).

13. Procédé selon la revendication 11, comprenant en outre de commander, par un panneau de commande externe connecté à une entrée de panneau de commande du contrôleur (250), des opérations du contrôleur.

14. Procédé selon la revendication 13, la commande comprenant les étapes suivantes :
en réponse à un signal de commande de désarmement reçu à l'entrée du panneau de commande du contrôleur (250), provoquer un état de circuit fermé du dispositif de commutation électromécanique (210) de l'entrée de chemin à la sortie de chemin (N30) ; et
en réponse à un signal de commande d'armement reçu à l'entrée du panneau de commande du contrôleur (250), provoquer l'état de circuit ouvert du dispositif de commutation électromécanique (210).

15. Procédé selon la revendication 11, dans lequel l'interruption, par le dispositif interrupteur de puissance de dérivation (201), comprend l'étape suivante :
transmettre l'événement de courant de défaut à au moins une diode de suppression de tension transitoire (TVS) (213, 215) de l'interrupteur de circuit à semi-conducteur connecté au chemin de moindre résistance (107) entre le dispositif de commutation électromécanique (210) et la sortie de chemin (N30), afin de supprimer une tension transitoire.
